# EUROPEAN PATENT SPECIFICATION

(11) **EP 2 904 672 B1**
(45) Date of publication and mention of the grant of the patent: **04.04.2018**
(21) Application number: 13763294.9
(22) Date of filing: 17.09.2013
(51) Int. Cl.: H01S 5/0625, H01S 5/10, H01S 5/125, H01S 5/34, H01S 5/00

(54) **DUAL WAVELENGTH LASING DEVICE**
LASERUNGSVORRICHTUNG MIT ZWEI WELLENLÄNGEN
DISPOSITIF D'ÉMISSION LASER À DOUBLE LONGUEUR D'ONDE

(30) Priority: 01.10.2012 GB 201217514
(43) Date of publication of application: 12.08.2015
(73) Proprietor: University College Cardiff Consultants Limited, Cardiff, South Glamorgan CF24 0DE (GB)
(72) Inventor: SMOWTON, Peter Michael, Penarth South Glamorgan CF64 1SD (GB); SHUTTS, Samuel, Ludlow Shropshire SY8 3AY (GB)
(74) Representative: Chapman IP
(86) International application number: PCT/GB2013/052419
(87) International publication number: WO 2014/053805

(56) References cited:
- US-A1- 2012 044 481
- MIRJAM MULLER ET AL: "Widely Tunable Photonic Crystal Coupled Cavity Lasers on GaSb", IEEE PHOTONICS TECHNOLOGY LETTERS, IEEE SERVICE CENTER, PISCATAWAY, NJ, US, vol. 20, no. 13, 1 July 2008 (2008-07-01), pages 1100-1102, XP011215751, ISSN: 1041-1135
- ROH S D ET AL: "Dual-wavelength InGaAs-GaAs ridge waveguide distributed Bragg reflector lasers with tunable mode separation", IEEE PHOTONICS TECHNOLOGY LETTERS, IEEE SERVICE CENTER, PISCATAWAY, NJ, US, vol. 12, no. 10, 1 October 2000 (2000-10-01), pages 1307-1309, XP011432048, ISSN: 1041-1135, DOI: 10.1109/68.883812
- SHUTTS S ET AL: "Deep etched distributed Bragg reflector (DBR) InP/AlGaInP quantum dot lasers", NOVEL IN-PLANE SEMICONDUCTOR LASERS X, SPIE, 1000 20TH ST. BELLINGHAM WA 98225-6705 USA, vol. 7953, no. 1, 10 February 2011 (2011-02-10), pages 1-9, XP060005536, DOI: 10.1117/12.876454 [retrieved on 2011-02-16]
- S. SHUTTS ET AL: "Intensity stability and wavelength separation in dual-lambda QD lasers", 2013 IEEE PHOTONICS CONFERENCE, 8 September 2013 (2013-09-08), - 12 September 2013 (2013-09-12), pages 236-237, XP055091349, DOI: 10.1109/IPCon.2013.6656523 ISBN: 978-1-45-771506-8

## Description

The present invention relates to a lasing device and particularly, but not exclusively, a dual wavelength semiconductor lasing device.

Multiple wavelength radiation sources have application in interferometric techniques such as Optical Coherence Tomography (OCT) and other distance and position interferometric measurements.

Multiple wavelength sources, particularly dual wavelength sources, also have applications in household technology. One example is Blu-Ray® and DVD players with backwards compatibility: Blu-Ray® discs, Digital Video Discs (DVDs) and Compact Discs (CDs) are each read at a different wavelength. Backwards compatibility is therefore only achieved if the later device is provided with means to read discs at a variety of wavelengths. For example, a Blu-Ray® player with backwards compatibility must include a 405nm wavelength source to enable reading of Blu-Ray® discs, in addition to a 650nm wavelength source and a 780nm wavelength source to enable reading of DVDs and CDs respectively. At present, one known way in which to achieve dual wavelength functionality for such devices is through the use of a separate laser and optic systems for each wavelength, which substantially increases the complexity and hence the production costs of the device. Alternatively, it is known to combine the two wavelength sources into an integral device. However, there remains a spatial separation between the two wavelength sources, which again complicates the optics of the device and hence augments the production costs. It is therefore desirable to produce a multiple wavelength source that is capable of emitting two or more wavelengths on the same optical axis.

Another substantial application of dual wavelength sources is in the production of so-called Terahertz radiation i.e. radiation having a frequency lying in the range of 0.3THz to 10 THz. This is achieved by coherently combining (i.e. "beating") together two modes having a frequency difference within the above-defined range. Terahertz radiation has a variety of practical applications, predominantly due to its ability to penetrate a wide range of materials. For example, terahertz radiation is frequently used by astronomers as a result of its ability to penetrate clouds and dust that might otherwise obscure the view of stellar matter. Terahertz radiation also has substantial applications in the security and defence sector. In view of the widespread applications of terahertz radiation, it is desirable to produce a multiple wavelength source that is capable of emitting two radiation modes having a frequency separation of between 0.3THz to 10 THz.

ROH S D ET AL: "Dual-wavelength InGaAs-GaAs ridge waveguide distributed Bragg reflector lasers with tunable mode separation", IEEE PHOTONICS TECHNOLOGY LETTERS, vol. 12, no. 10,1 October 2000 discloses a dual wavelength ridge waveguide distributed Bragg reflector laser with tunable mode separation.The lasing device comprises, in the order from an output facet, a gain section, a front DBR grating, a spacing section and a back DBR grating. An active layer extends through all these sections. Two lasing cavities are formed between the output facet and the front/back DBR, respectively, wherein a wavelength reflected by the front DBR is slightly longer than the wavelength reflected by the back DBR. Only the gain section is biased to achieve lasing at two wavelengths generated in the two lasing cavities. Current may be injected into the front DBR for wavelength tuning.

We have now devised a semiconductor lasing device to meet at least some of the above-described needs.

In accordance with the present invention there is provided a semiconductor lasing device comprising an active layer, the active layer comprising a first portion and a second portion, the first and second portions being separated by grating, the first portion defining a first lasing cavity for emitting electromagnetic radiation at a first wavelength and the first and second portions together defining a second lasing cavity for emitting electromagnetic radiation at a second wavelength which is greater than the first wavelength, wherein the grating has a high reflectivity with respect to the first wavelength and a high transmissivity with respect to the second wavelength and comprises a plurality of channels extending through the entire depth of the active layer, said first portion of the device comprising a first pair of electrical contacts for driving the first lasing cavity and the second portion of the device comprising a second pair of electrical contacts for driving the second lasing cavity. The term "active layer' as used herein refers to a region comprising an amplifying medium and associated layers for providing efficient injection of charge carriers and optical waveguiding.

One advantage of the present invention is that the grating acts to electrically isolate the first and second portions and therefore enables separate pumping of the first and second lasing cavities.

Preferably the channels extend to a depth at least equal to a substantially full depth of an optical mode at the first wavelength and at least equal to a substantially full depth of an optical mode at the second wavelength. As used herein, the term "full depth" refers to the depth over which the optical mode tends to a very small intensity.

One advantage of having channels that extend down to a full depth of the optical modes propagating in the device is that the waveguiding shows no preferential direction in the vertical direction and thus there is no preferential upwards or downwards guiding of the optical mode.

Preferably the active layer is disposed on a substrate. The plurality of channels may extend to the substrate. There may be a first cladding layer disposed intermediate the substrate and the active layer for further confinement of the optical mode. In this embodiment, the plurality of channels may extend to the substrate or, if the cladding layer is of a sufficient thickness, may extend through a substantial depth of the cladding layer but not completely to the substrate.

The device may comprise a second cladding layer such that the active layer is disposed intermediate the first and second cladding layers. The first and second cladding layers are preferably formed of a semiconductor material having one of: n-type and p-type doping respectively, or p-type and n-type doping respectively.

The grating has a high reflectivity with respect to the first wavelength and a high transmissivity with respect to the second wavelength. The grating is preferably a Bragg reflection grating and most preferably a Distributed Bragg Reflector (DBR). The DBR is preferably a quarter-wave grating of first or higher order.

The first and second wavelengths are preferably in the wavelength range encompassed by semiconductor materials and more preferably between 650nm and 730nm. The second wavelength is greater than the first wavelength. This wavelength regime is favourable for biomedical applications such as excitation of fluorescent dyes since absorption, scattering and auto-fluorescence of biological substrates is minimised. However, it will be appreciated that the wavelength regime may be selected in accordance with the desired application of the device.

The lasing device preferably comprises a longitudinal axis, the first portion and the second portion being preferably separated along said longitudinal axis. The length of the second portion in a direction parallel to the longitudinal axis of the device is preferably greater than the length of the first portion in a direction substantially parallel to the longitudinal axis of the device.

The first and second portions of the device are preferably formed integrally, the lasing device preferably comprising a single substrate that extends across the first and second portions.

An optical axis of the first lasing cavity is preferably substantially parallel to said longitudinal axis, and is most preferably substantially coaxial with said longitudinal axis.

An optical axis of the second lasing cavity is preferably substantially parallel to said longitudinal axis, and is most preferably substantially coaxial with said longitudinal axis. It will be appreciated that in this preferred embodiment, the optical axis of the second lasing cavity is substantially coaxial with the optical axis of the first lasing cavity.

Preferably the device comprises a dual wavelength mode of operation in which the device is adapted for emitting electromagnetic radiation at the first wavelength and at the second wavelength simultaneously. Alternatively, or in addition thereto, the device preferably comprises a single wavelength mode of operation in which the device is adapted for either emitting electromagnetic radiation at the first wavelength or emitting electromagnetic radiation at the second wavelength. In the most preferable embodiment, the device is selectively reconfigurable between said dual wavelength mode of operation and said single wavelength mode of operation.

The active layer of the lasing device may comprise a bulk semiconductor. Alternatively, the active layer may comprise a quantum well material i.e. a material having an active layer of thickness approximately equal to the deBroglie wavelength of an electron and/or hole. The most preferable embodiment is one in which the active layer comprises a plurality of quantum dots, which may be in one or more quantum wells (so-called dot-in-well or D-WELL material). It will be appreciated that the population inversion required for lasing is achieved more efficiently in an active material having a reduced effective dimensionality i.e. population inversion is achieved most effectively in an active material comprising a plurality of quantum dots. Furthermore, the radiation emitted by a lasting device having a dot-in-a-well active material is determined by the physical dimensions of the quantum dots rather than the band-gap energy of the semiconductor, which provides the possibility of finely tuning the wavelength of the radiation emitted by the device.

Preferably the active layer comprises a number or density of states that is larger at higher energies. Most preferably, the number or density of states of the active layer is higher at energies corresponding to the first wavelength than at energies corresponding to the second wavelength.

The first portion of the device comprises a first pair of electrical contacts for driving the first lasing cavity. The second portion of the device comprises a second pair of electrical contacts for driving the second lasing cavity. One of the first pair of electrical contacts may also function as one of the second pair of electrical contacts. Alternatively, one contact from each of the pairs of contacts may be electrically connected. The first and second pair of electrical contacts may be operated separately in order to allow selective operation of the first and second lasing cavities.

The length of the first lasing cavity in a direction substantially parallel to the longitudinal axis of the device is preferably selected to provide sufficient optical gain at the first wavelength. Preferably the length of the first lasing cavity is one of: an integer multiple of the first wavelength; or an integer multiple of the first wavelength plus half of the first wavelength. It will be appreciated that these lengths facilitate the formation of a standing wave having wavelength equal to the first wavelength within the first cavity.

The length of the second lasing cavity in a direction substantially parallel to the longitudinal axis of the device is preferably selected to provide sufficient optical gain at the second wavelength. Preferably the length of the second lasing cavity is one of: an integer multiple of the second wavelength; or an integer multiple of the second wavelength plus half of the second wavelength. It will be appreciated that these lengths facilitate the formation of a standing wave having wavelength equal to the second wavelength within the second cavity.

The device may be adapted for emitting more than two wavelengths of radiation. For example, the device may comprise a third portion at a distal end of the second portion and separated therefrom by a second grating, the first, second and third portions together defining a third lasing cavity for emitting electromagnetic radiation at a third wavelength. The second grating preferably comprises a plurality of channels etched down to a substrate layer and preferably comprises a high reflectivity with respect to the second wavelength and a high transmissivity with respect to the third wavelength. The preferred features described in relation to the first and second portions and/or the first and second lasing cavities apply equally to the third portion and/or the third lasing cavity respectively. It will be appreciated that this may be extended to include any number of portions and lasing cavities.

The lasing device preferably comprises a first face at an end of the device proximal to the first portion. The first face is preferably substantially planar, having a normal in a direction substantially parallel to the longitudinal axis of the device. The first face preferably comprises an output coupler having a partial transmissivity with respect to each of the wavelengths generated in the device. For example, in the embodiment in which the device comprises first and second portions only, the first face preferably comprises an output coupler having a partial transmissivity with respect to the first and second wavelengths. The first face may comprise a grating.

The lasing device preferably comprises a second face at an end of the device distal to the first portion. For example, in the embodiment in which the device comprises first and second portions only, the second face is disposed at a distal end of the second portion, and in the embodiment in which the device comprises first, second and third portions, the second face is disposed at a distal end of the third portion. The second face is preferably substantially planar, having a normal in a direction substantially parallel to the longitudinal axis of the device. The second face preferably comprises a high reflectivity with respect to each of the wavelengths generated in the device. For example, in the embodiment in which the device comprises first and second portions only, the second face preferably comprises high reflectivity with respect to the first and second wavelengths. The second face may comprise a grating having a high reflectivity with respect to the second wavelength, the grating being preferably etched down to the substrate layer, which may for example be a Distributed Bragg Reflector (DBR) or a Distributed Feedback Grating (DFB).

An embodiment of the present invention will now be described by way of example only and with reference to the accompanying drawings, in which:

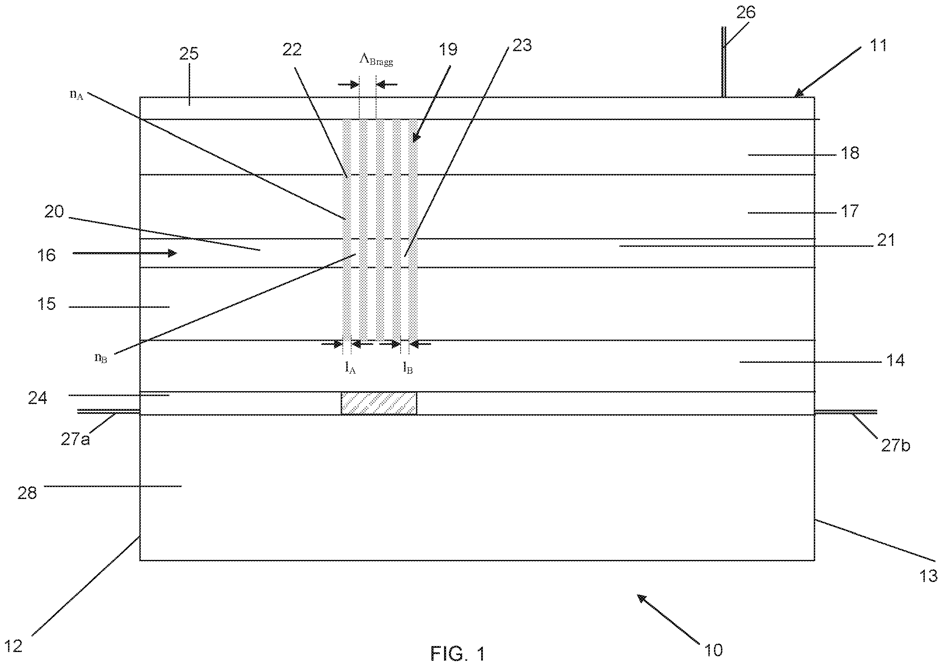

Figure 1 is a schematic illustration of a semiconductor lasing device in accordance with the present invention (not drawn to scale); and,
Figure 2(a) is a schematic illustration of a portion of the device illustrated in Figure 1 illustrating a first lasing cavity; and,
Figure 2(b) is a schematic illustration of a portion of the device illustrated in Figure 1 illustrating a second lasing cavity.

With reference to the drawings, there is illustrated a laser diode 10 for emitting radiation at first and second distinct wavelengths λ₁, λ₂. These wavelengths λ₁, λ₂ are typically in the range 600nm to 800nm with λ₂ > λ₁. Example numerical values are: λ₁ = 650nm and λ₂ = 710nm. This is favourable for biomedical applications (such as excitation of fluorescent dyes) since absorption, scattering and auto-fluorescence of biological substrates is minimised.

The laser diode 10 is of the double heterostructure type having a generally cuboidal body portion 11 with first and second substantially planar faces 12, 13 at opposing ends of a longitudinal axis. The first and second faces 12, 13 are substantially parallel to one another and may be formed by cleaving or other suitable process. The body portion 11 has dimensions in the micrometer range, for example a length of approximately 1800µm, a width of approximately 300µm, and a height of approximately 100µm.

The laser diode 10 comprises a substrate layer 14 formed of a semiconductor material upon which metal may readily bond and upon which further layers may be grown by metal organic vapour phase epitaxy (MOVPE) or molecular beam epitaxy (MBE) or the like. A suitable material is n-type GaAs but other semiconductor materials may also be suitable.

A first cladding layer 15 is formed on the substrate layer 14 by metal organic vapour phase epitaxy (MOVPE) or other suitable process. The first cladding layer 15 is formed of a doped semiconductor, the doping being of the same type as the substrate layer 14. A suitable material for the first cladding layer 15 is n-type AlInP but other doped semiconductors may also be suitable. A suitable width for the first cladding layer 15 is 1000nm.

An active layer 16 is formed on the first cladding layer 15 by metal organic vapour phase epitaxy (MOVPE) or other suitable process. The active layer 16 comprises an amplifying medium, associated layers to confine electrons and holes in the amplifying medium, and additional material to provide a sufficient width to contain most of the optical mode. In the illustrated embodiment, the active layer 16 has a quantum dot structure comprising five dot in well (D-WELL) layers separated by 16 nm wide (Al_{0.3}Ga_{0.7})_{0.51}In_{0.49}P barrier layers. Each D-WELL layer is formed by depositing 2 to 3 monolayers of InP material on (Al_{0.3}Ga_{0.7})_{0.51}In_{0.49}P and covering with 8 nm Ga_{0.51}In_{0.49}P quantum wells. Each dot in well (D-WELL) layer is separated by 16 nm wide (Al_{0.3}Ga_{0.7})_{0.51}In_{0.49}P barrier layers. It has been shown that such samples exhibit a bi-modal distribution of dot size and it is the growth temperature which governs both the mean dot size and the density of dots in each subset. It has been found by the authors that a significant intermixing between the inhomogeneously broadened ground and excited states of the two dot subsets can be achieved through optimisation of the quantum dot size distribution. This results in a relatively broad, flat topped gain spectrum from which a large range of lasing wavelengths can be accessed.

A second cladding layer 17 is formed above the active layer 16, again by metal organic vapour phase epitaxy (MOVPE) or other suitable process. The second cladding layer 17 is formed of a semiconductor having an opposing doping to the first cladding layer 15 so as to create a depletion region intermediate the two cladding layers 15, 17 i.e. in the active layer 16. For example, the second cladding layer 17 may be formed of p-type AlInP. A suitable width for the second cladding layer 17 is 1000nm.

A cap 18 covers the second cladding layer 17. The cap 18 is formed of a semiconductor material having the same doping as the second cladding layer 17. The material of the cap 18 should also be chosen so as to facilitate bonding of a metallic layer to the cap 18. By way of example, a suitable material for the cap 18 is p-type GaAs.

It will be appreciated that whilst the substrate 14 and first cladding layer 15 of the illustrated embodiment have n-type doping and the cap 18 and second cladding layer 17 have p-type doping, this arrangement could be reversed such that the substrate 14 and first cladding layer 15 of the illustrated embodiment have p-type doping and the cap 18 and second cladding layer 17 have n-type doping.

A deep etched grating in the form of a Distributed Bragg Reflector (DBR) 19 is formed within the body portion 11. The grating 19 separates the active layer 16 into a first portion 20 a first side of the grating 19 and a second portion 21 a second side of the grating 19.

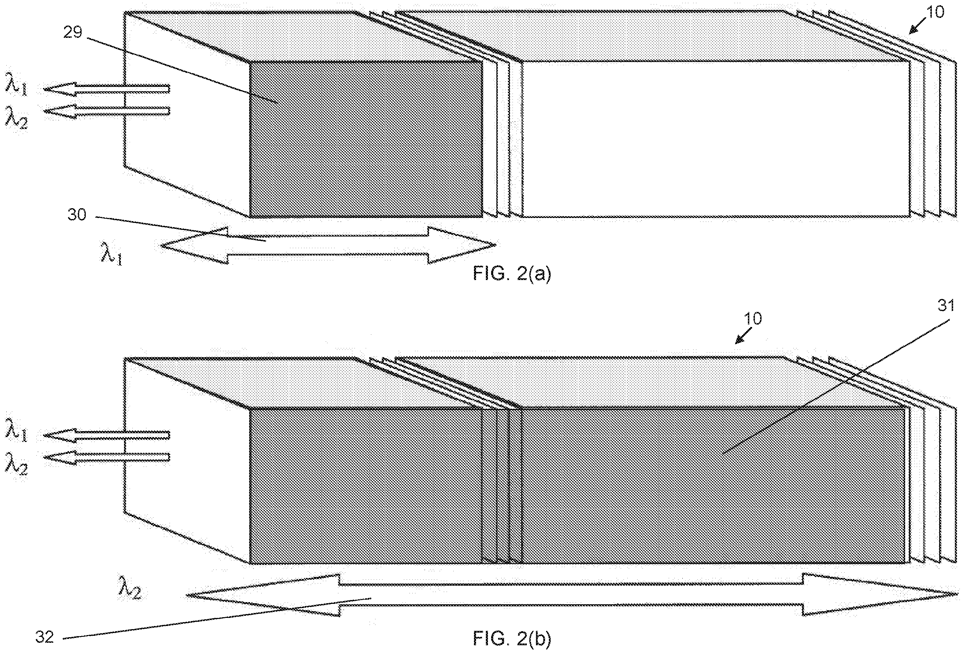

The grating 19 is formed by etching a plurality of channels 22 into the second cladding layer 17, the active layer 16 and the first cladding layer 15. In the illustrated embodiment, the grating 19 extends down to the top of the substrate layer 14. It will be appreciated, however, that the channels 22 of the grating 19 may alternatively extend some depth into the substrate layer 14 or may not extend completely to the substrate layer 14 if the lower cladding layer 15 is sufficiently thick. Whilst Figure 2 depicts 5 channels 22, it will be appreciated that the grating 19 may comprise greater or fewer than 5 channels; a typical DBR grating 19 comprises between 3 and 50 channels 22. Once etched, the channels 22 are filled with a dielectric material such as benzocyclobutene (BCB).

The grating 19 is a quarter-wave grating designed to have a high reflectivity at the first wavelength λ₁ and a high transmissivity at the second wavelength λ₂. Accordingly, the optical width n_{A}l_{A} of each channel 22 of the grating is equal to an odd integer multiple of ¼λ₁ (where n_{A} is the refractive index of the channels 22 at the first wavelength λ₁; l_{A} is the physical width of the channels 22; and λ₁ represents a vacuum wavelength). Similarly, the optical width n_{B}l_{B} of each of the ridges 23 intermediate the channels 22 in the active layer 16 is equal to an odd integer multiple of ¼λ₁ (where n_{B} is the refractive index of the active material 16 for the appropriate optical mode at the first wavelength λ₁ and l_{B} is the physical width of the ridge 23). It will be appreciated, however, that this requirement for the optical width of the channels 22 and ridges 23 to each separately equal an odd integer multiple of ¼λ₁ may be somewhat relaxed providing the sum of the optical widths of a channel 22 and adjacent ridge 23 is a multiple of ½λ₁.

The applicants have found that quarter-wave gratings of third or fifth order provide a good result i.e. the optical width of each channel 22 and each ridge 23 is ideally equal to (3 x ¼ λ₁) or (5 x ¼ λ₁).

For channels 22 formed of benzocyclobutene (BCB), the refractive index n_{A} is approximately 1.5. Taking λ₁ = 650nm gives a physical channel width l_{A} of approximately 320nm for a third order quarter wave grating or 540nm for a fifth order quarter wave grating. For ridges 23 having layers formed of the above-described cladding layer 15, 17 active layer 16 and cap 18 materials, the refractive index n_{B} is are approximately 3.5. Taking λ₁ = 650nm gives a physical ridge width l_{B} of approximately 140nm for a third order quarter wave grating or 230nm for a fifth order quarter wave grating. Accordingly, the period Λ_{Bragg} = l_{A} + l_{B} of the grating 19 is approximately 460nm for a third order quarter wave grating or 770nm for a fifth order quarter wave grating.

A metallic lower layer 24 and a metallic upper layer 25 are formed below the substrate 14 and above the cap 18 respectively. The metallic layers 24, 25 may be formed by evaporation, or by sputtering, or by any technique known in the art. The lower metallic layer 24 comprises two electrically isolated portions: a first portion below the first portion 20 of the active layer 16 and a second portion below the second portion 21 of the active layer 16. The upper metallic layer 25 comprises a continuous layer. However, it will be appreciated that the lower metallic layer 24 can alternatively comprise a continuous layer and the upper metallic layer 25 may comprise first and second electrically isolated portions above the first and second portions 20, 21 of the active layer 16 respectively. In a third alternative, the lower metallic layer 24 and upper metallic layer may both comprise first and second electrically isolated portions.

An upper electrode lead 26 is coupled to the upper metallic layer 25. A pair of lower electrode leads 27a, 27b are coupled to the lower metallic layer 24, a first lead 27a being coupled to the first portion of the lower metallic layer 24 and a second lead 27b being coupled to the second portion of the lower metallic layer 24. The coupling may be achieved by standard wire bonding technology. It will be appreciated that in the above-mentioned embodiment in which the upper metallic layer 5 comprises first and second electrically isolated portions, a second upper electrode lead (not shown) will be required.

The lower electrode leads 27a, 27b are separately coupled to an electrical power supply (not shown) such that a first potential difference may be established between the upper electrode lead 26 and the first lower electrode lead 27a, and a second potential difference may be established between the upper electrode lead 26 and the second lower electrode lead 27b. Accordingly, the upper electrode lead 26 and first lower electrode lead 27a are adapted for biasing the first portion 20 of the active layer 16. Similarly, the upper electrode lead 26 and second lower electrode lead 27b are adapted for biasing the second portion 21 of the active layer 16.

A heat sink 28 is provided below the lower metallic layer 24. The heat sink 28 may be formed of silicon or any other material known in the art for such a purpose.

The first planar face 12 comprises an output coupler (not shown) having a partial transmissivity with respect to the first and second wavelengths λ₁, λ₂. For example, the transmisstivity may be approximately 70%. The second face 13 comprises a second Distributed Bragg Reflector (DBR) having a reflectivity of above 90% with respect to the second wavelength λ₂.

In use, a first current I₁ is supplied to between the upper electrode 26 and the first lower electrode 27a. The first current I₁ is selected such that stimulated emission predominantly occurs at the first wavelength λ_{1;} for λ₁= 650nm, a first current of I₁ = 105mA has been found to be appropriate. This current I₁ creates a potential difference between the electrodes 26, 27a and hence biases the first portion 20 of the laser diode 10. Accordingly, charge carriers are injected into the amplifying medium of the active layer 16 from the associated layers of the active layer 16 and from the cladding layers 15, 17, resulting in a simultaneous high population of electrons and holes in the active layer 16 and hence a population inversion. Consequently, stimulated emission at the first wavelength λ₁ is achieved. An optical mode at the first wavelength λ₁ propagates in an optical waveguide 29 defined by the active layer 16, cladding layers 15, 17, first face 12 and deep-etched grating 19. The length 30 of the waveguide 29 i.e. distance between the first face 12 and the deep-etched grating 19 is selected to provide optical gain. Ideally, the length 30 is an integer number of half wavelengths (n x ½ λ₁ for integer n) in order to facilitate multipass amplification. It has been found that a length 30 of 300µm is suitable but other lengths may also be suitable.

A second current I₂ may also be supplied between the upper electrode 26 and the second lower electrode 27b. The second current I₂ is selected such that stimulated emission predominantly occurs at the second wavelength λ_{2;} for λ₂= 710nm, a value of I₂ = 15mA has been found to be appropriate. This current is I₂ creates a potential difference between the electrodes 26, 27b and hence biases the second portion 21 of the laser diode 10. The deep-etched grating 19 electrically isolates the second portion 21 of the diode 10 from the first portion 20 thereof, thereby and therefore enabling selective biasing of the first and second portions 20, 21. The biasing of the second portion 21 of the diode 10 results in an injection of charge carriers into the active layer 16 of this portion and hence stimulated emission at the second wavelength λ₂. An optical mode at the second wavelength λ₂ propagates in an optical waveguide 31 defined by the active layer 16, cladding layers 15, 17, first planar face 12 and second planar face 13. It will be appreciated that the deep-etched grating 19 is substantially transparent at the second wavelength λ₂. The length 32 of the waveguide 31 i.e. the distance between the first planar face 12 and the second planar face 13 is selected to provide optical gain. Ideally the length 32 is an integer number of half wavelengths (n x ½ λ₂ for integer n) in order to facilitate multipass amplification. It has been found that a length 32 of 1500µm is suitable but other lengths may also be suitable. Since the grating 19 extends to the depth of the optical mode at the second wavelength λ₂, there is no preferential upward or downward guiding of this optical mode.

The laser diode 10 may be operated in single wavelength mode in which either the first current I₁ is applied or the second current I₂ is applied. Alternatively, the laser diode 10 may be operated in dual wavelength mode, in which the first current I₁ and the second current I₂ are applied simultaneously. It has been found by the applicants that there is minimal competition between the dot states of the above-described D-WELL structure involved in the emission at the first and second wavelengths λ₁, λ₂ and hence dual wavelength operation is not suppressed. The two wavelengths λ₁, λ₂ may be utilised separately or may be combined to give radiation of a third wavelength λ₃ corresponding to a frequency equal to the beat frequency of the first and second wavelengths λ₁, λ₂. In this way, the laser diode 10 may act as a source of Terahertz radiation.

Whilst the above-described embodiment is adapted for emitting radiation at first and second wavelengths λ₁, λ₂, it will be appreciated that the present invention also encompasses devices adapted for emitting more than two wavelengths of radiation. For example, the device may comprise a third portion at a distal end of the second portion and separated therefrom by a second grating, the first, second and third portions together defining a third lasing cavity for emitting electromagnetic radiation at a third wavelength λ₃. In this embodiment, the second grating would comprise a grating similar to the deep-etched grating 19 intermediate the first and second portions 20, 21 but having high reflectivity with respect to the second wavelength λ₂ and a high transmissivity with respect to the third wavelength λ₃.

From the foregoing therefore, it is evident that the present invention enables the alternate or simultaneous emission of radiation at more than one wavelength.

## Claims

1. A dual wavelength semiconductor lasing device (10) comprising an active layer (16), the active layer comprising a first portion (20) and a second portion (21), the first and second portions being separated by grating (19), the first portion defining a first lasing cavity (29) for emitting electromagnetic radiation at a first wavelength and the first and second portions together defining a second lasing cavity (31) for emitting electromagnetic radiation at a second wavelength which is greater than the first wavelength, wherein the grating has a high reflectivity with respect to the first wavelength and a high transmissivity with respect to the second wavelength and comprises a plurality of channels (22) extending through the entire depth of the active layer, said first portion of the device comprising a first pair of electrical contacts for driving the first lasing cavity and the second portion of the device comprising a second pair of electrical contacts for driving the second lasing cavity.

2. A lasing device according to claim 1, wherein the channels extend to a depth at least equal to a substantially full depth of an optical mode at the first wavelength and at least equal to a substantially full depth of an optical mode at the second wavelength, the active layer being disposed on a cladding layer (15) which is disposed on a substrate (14), said channels extending towards the substrate.

3. A lasing device according to claim 2, wherein the channels extend through a substantial depth of the cladding layer but not completely to the substrate.

4. A lasing device according to claims 2 or 3, further comprising a second cladding layer such that the active layer is disposed intermediate the first and second cladding layers

5. A lasing device according to any preceding claim, wherein the first and second portions of the device are formed integrally, the lasing device comprising a single substrate that extends across the first and second portions.

6. A lasing device according to claim 5, wherein the length of the second portion in a direction parallel to a longitudinal axis of the device is greater than the length of the first portion in a direction substantially parallel to the longitudinal axis of the device.

7. A lasing device according to claim 6, wherein the length of the first lasing cavity in a direction substantially parallel to the longitudinal axis of the device is selected to provide sufficient optical gain for lasing to occur at the first wavelength, and wherein the length of the second lasing cavity in a direction substantially parallel to the longitudinal axis of the device is selected to provide sufficient optical gain for lasing to occur at the second wavelength

8. A lasing device according to any preceding claim, wherein an optical axis of the second lasing cavity is substantially coaxial with an optical axis of the first lasing cavity.

9. A lasing device according to any preceding claim, wherein the device is selectively reconfigurable to emit electromagnetic radiation at the first wavelength and/or the second wavelength.

10. A lasing device according to any preceding claim, wherein the active layer comprises a plurality of quantum dots in one or more quantum wells.

11. A lasing device according any preceding claim, wherein the density of states of the active layer is higher at energies corresponding to the first wavelength than at energies corresponding to the second wavelength.

12. A lasing device according to any preceding claim, wherein the device comprises a first substantially planar face at end of the device proximal to the first portion, said first face comprising an output coupler having a partial transmissivity with respect to the first and second wavelengths.

13. A lasing device according to claim 12, wherein the first face comprises a grating.

14. A lasing device according to claim 12 or 13, wherein the device comprises a second substantially planar face at a distal end of the second portion, said second face comprising a high reflectivity with respect to the second wavelength.

15. A lasing device according to claim 14, wherein the second face comprises a grating that extends through the entire depth of the active layer.

## Patentansprüche

1. Halbleiter-Laserungsvorrichtung mit zwei Wellenlängen (10),
umfassend eine aktive Schicht (16),
wobei die aktive Schicht einen ersten Abschnitt (20) und einen zweiten Abschnitt (21) umfasst, wobei der erste und zweite Abschnitt durch ein Gitter (19) getrennt sind, wobei der erste Abschnitt einen ersten
Laserungshohlraum (29)
zum Emittieren von elektromagnetischer Strahlung einer ersten Wellenlänge definiert und der erste und zweite Abschnitt zusammen einen zweiten Laserungshohlraum (31)
zum Emittieren von elektromagnetischer Strahlung einer zweiten Wellenlänge, die größer ist, als die erste Wellenlänge, definieren, wobei das Gitter in Bezug auf die erste Wellenlänge eine hohe Reflektivität und in Bezug auf die zweite Wellenlänge ein hohes Durchlassvermögen aufweist und eine Vielzahl von Kanälen (22) umfasst,
die sich durch die gesamte Tiefe der aktiven Schicht erstrecken, wobei der erste Abschnitt der Vorrichtung ein erstes Paar elektrischer Kontakte zum Ansteuern des ersten Laserungshohlraums umfasst und der zweite Abschnitt der Vorrichtung ein zweites Paar elektrischer Kontakte zum Ansteuern des zweiten Laserungshohlraums umfasst.

2. Laserungsvorrichtung nach Anspruch 1, wobei sich die Kanäle auf eine Tiefe erstrecken, die mindestens gleich einer im Wesentlichen gesamten Tiefe eines optischen Modus auf der ersten Wellenlänge und mindestens gleich einer im Wesentlichen gesamten Tiefe eines optischen Modus auf der zweiten Wellenlänge ist, wobei die aktive Schicht auf einer Deckschicht (15) angeordnet ist, die auf einem Substrat (14) angeordnet ist,
wobei sich die Kanäle in Richtung des Substrats erstrecken.

3. Laserungsvorrichtung nach Anspruch 2, wobei sich die Kanäle durch eine wesentliche Tiefe der Deckschicht erstrecken, aber nicht komplett zum Substrat.

4. Laserungsvorrichtung nach Anspruch 2 oder 3, ferner umfassend eine zweite Deckschicht, so dass die aktive Schicht zwischen der ersten und zweiten Deckschicht angeordnet ist.

5. Laserungsvorrichtung nach einem der vorhergehenden Ansprüche, wobei der erste und zweite Abschnitt der Vorrichtung einstückig ausgebildet sind, wobei die Laserungsvorrichtung ein einzelnes Substrat umfasst, das sich über den ersten und zweiten Abschnitt erstreckt.

6. Laserungsvorrichtung nach Anspruch 5, wobei die Länge des zweiten Abschnitts in einer Richtung parallel zu einer Längsachse der Vorrichtung größer ist als die Länge des ersten Abschnitts in einer Richtung im Wesentlichen parallel zur Längsachse der Vorrichtung.

7. Laserungsvorrichtung nach Anspruch 6, wobei die Länge des ersten Laserungshohlraums in einer Richtung im Wesentlichen parallel zur Längsachse der Vorrichtung ausgewählt ist, um ausreichend optische Verstärkung bereitzustellen, damit Laserung bei der ersten Wellenlänge auftritt, und wobei die Länge des zweiten Laserungshohlraums in einer Richtung im Wesentlichen parallel zur Längsachse der Vorrichtung ausgewählt ist, um ausreichend optische Verstärkung bereitzustellen, damit Laserung bei der zweiten Wellenlänge auftritt.

8. Laserungsvorrichtung nach einem der vorhergehenden Ansprüche, wobei eine optische Achse des zweiten Laserungshohlraums im Wesentlichen koaxial zu einer optischen Achse des ersten Laserungshohlraums ist.

9. Laserungsvorrichtung nach einem der vorhergehenden Ansprüche, wobei die Vorrichtung selektiv rekonfigurierbar ist, um elektromagnetische Strahlung der ersten Wellenlänge und/oder der zweiten Wellenlänge auszusenden.

10. Laserungsvorrichtung nach einem der vorhergehenden Ansprüche, wobei die aktive Schicht eine Vielzahl von Quantenpunkten in einer oder mehreren Quantenmulden umfasst.

11. Laserungsvorrichtung nach einem der vorhergehenden Ansprüche, wobei die Dichte von Zuständen der aktiven Schicht bei Energien, die der ersten Wellenlänge entsprechen, höher ist als bei Energien, die der zweiten Wellenlänge entsprechen.

12. Laserungsvorrichtung nach einem der vorhergehenden Ansprüche, wobei die Vorrichtung eine erste im Wesentlichen ebene Fläche am Ende der Vorrichtung proximal zum ersten Abschnitt umfasst, wobei die erste Fläche einen Ausgangskoppler umfasst, der in Bezug auf die erste und zweite Wellenlänge ein partielles Durchlassvermögen aufweist.

13. Laserungsvorrichtung nach Anspruch 12, wobei die erste Fläche ein Gitter umfasst.

14. Laserungsvorrichtung nach Anspruch 12 oder 13, wobei die Vorrichtung eine zweite im Wesentlichen ebene Fläche an einem distalen Ende des zweiten Abschnitts umfasst, wobei die zweite Fläche in Bezug auf die zweite Wellenlänge eine hohe Reflektivität aufweist.

15. Laserungsvorrichtung nach Anspruch 14, wobei die zweite Fläche ein Gitter umfasst, das sich durch die gesamte Tiefe der aktiven Schicht erstreckt.

## Revendications

1. Dispositif à effet laser à semi-conducteur à double longueur d'onde (10) comprenant une couche active (16),
la couche active comportant une première partie (20) et une seconde partie (21), les première et seconde parties étant séparées par un réseau (19), la première partie définissant une première cavité à effet laser (29) destinée à émettre un rayonnement électromagnétique à une première longueur d'onde et les première et seconde parties définissant conjointement une seconde cavité à effet laser (31) destinée à émettre un rayonnement électromagnétique à une seconde longueur d'onde qui est supérieure à la première longueur d'onde, le réseau présentant une réflectivité élevée par rapport à la première longueur d'onde et une transmissivité élevée par rapport à la seconde longueur d'onde et comportant une pluralité de conduits (22) s'étendant sur toute la profondeur de la couche active, ladite première partie du dispositif comportant une première paire de contacts électriques destinés à commander la première cavité à effet laser et la seconde partie du dispositif comportant une seconde paire de contacts électriques destinés à commander la seconde cavité à effet laser.

2. Dispositif à effet laser selon la revendication 1, dans lequel les conduits s'étendent sur une profondeur au moins égale à une profondeur sensiblement totale d'un mode optique à la première longueur d'onde et au moins égale à une profondeur sensiblement totale d'un mode optique à la seconde longueur d'onde, la couche active étant disposée sur une couche de revêtement (15) disposée sur un substrat (14), lesdits conduits s'étendant vers le substrat.

3. Dispositif à effet laser selon la revendication 2, dans lequel les conduits s'étendent sur une grande profondeur de la couche de revêtement mais pas entièrement jusqu'au substrat.

4. Dispositif à effet laser selon la revendication 2 ou 3, comprenant en outre une seconde couche de revêtement de sorte que la couche active est disposée entre les première et seconde couches de revêtement.

5. Dispositif à effet laser selon l'une quelconque des revendications précédentes, dans lequel les première et seconde parties du dispositif sont formées d'un seul tenant, le dispositif à effet laser comportant un substrat unique qui s'étend d'un côté à l'autre des première et seconde parties.

6. Dispositif à effet laser selon la revendication 5, dans lequel la longueur de la seconde partie dans une direction parallèle à un axe longitudinal du dispositif est supérieure à la longueur de la première partie dans une direction sensiblement parallèle à l'axe longitudinal du dispositif.

7. Dispositif à effet laser selon la revendication 6, dans lequel la longueur de la première cavité à effet laser dans une direction sensiblement parallèle à l'axe longitudinal du dispositif est sélectionnée pour produire un gain optique suffisant pour que l'effet laser se produise à la première longueur d'onde, et dans lequel la longueur de la seconde cavité à effet laser dans une direction sensiblement parallèle à l'axe longitudinal du dispositif est sélectionnée pour produire un gain optique suffisant pour que l'effet laser se produise à la seconde longueur d'onde.

8. Dispositif à effet laser selon l'une quelconque des revendications précédentes, dans lequel un axe optique de la seconde cavité à effet laser est sensiblement coaxial à un axe optique de la première cavité à effet laser.

9. Dispositif à effet laser selon l'une quelconque des revendications précédentes, dans lequel le dispositif est reconfigurable sélectivement pour émettre un rayonnement électromagnétique à la première longueur d'onde et/ou à la seconde longueur d'onde.

10. Dispositif à effet laser selon l'une quelconque des revendications précédentes, dans lequel la couche active comporte une pluralité de points quantiques dans un ou plusieurs puits quantiques.

11. Dispositif à effet laser selon l'une quelconque des revendications précédentes, dans lequel la densité d'états de la couche active est plus élevée aux énergies correspondant à la première longueur d'onde qu'aux énergies correspondant à la seconde longueur d'onde.

12. Dispositif à effet laser selon l'une quelconque des revendications précédentes, dans lequel le dispositif comporte une première face sensiblement plane à l'extrémité du dispositif qui est proximal par rapport à la première partie, ladite première face comportant un coupleur de sortie ayant une transmissivité partielle pour les première et seconde longueurs d'onde.

13. Dispositif à effet laser selon la revendication 12, dans lequel la première face comporte un réseau.

14. Dispositif à effet laser selon la revendication 12 ou 13, dans lequel le dispositif comporte une seconde face sensiblement plane à une extrémité distale de la deuxième partie, ladite seconde face présentant une réflectivité élevée pour la seconde longueur d'onde.

15. Dispositif à effet laser selon la revendication 14, dans lequel la seconde face comporte un réseau qui s'étend sur toute la profondeur de la couche active.
